# EUROPEAN PATENT APPLICATION

(11) **EP 4 692 926 A2**
(43) Date of publication of application: **11.02.2026**
(21) Application number: 25193651.4
(22) Date of filing: 04.08.2025
(51) Int. Cl.: G03F 1/24, G03F 1/42

(54) **REFLECTIVE MASK BLANK AND METHOD FOR MANUFACTURING THE SAME**

(30) Priority: 09.08.2024 JP 2024134298; 26.05.2025 JP 2025087509
(71) Applicant: Shin-Etsu Chemical Co., Ltd., Tokyo 100-0005 (JP)
(72) Inventor: Takeda, Atsuhiro, Niigata (JP); Muneyasu, Riku, Niigata (JP)
(74) Representative: Schicker, Silvia

(57) **Abstract**

A reflective mask blank according to the present invention includes at least: a substrate; a multilayer reflective film provided on the substrate and reflecting exposure light; and an absorber film provided on the multilayer reflective film and absorbing the exposure light; wherein the reflective mask blank comprises a reference mark serving as a reference position for detecting a defect position and formed on a surface of the reflective mask blank on a same side as the multilayer reflective film; and the reference mark has at least two pairs of parallel line segments, each pair consisting of two parallel line segments in a concave or convex shape, and the directions of the two pairs of parallel line segments are in a position perpendicular to each other. This makes it possible to produce a reference mark at a relatively low cost and with high throughput, and to improve the accuracy of the position detection achieved by a detector.

## Description

The present invention relates to a reflective mask blank that is used for manufacturing semiconductor devices, etc. and a method for manufacturing the same.

### BACKGROUND ART

In the manufacturing process of semiconductor devices (semiconductor equipment), a photolithography technique is repeatedly used in which a transfer mask is irradiated with exposure light and the circuit pattern formed on the mask is transferred onto a semiconductor substrate (semiconductor wafer) via a reduced projection optical system. Conventionally, the wavelength of exposure light is mainly 193 nm produced using argon fluoride (ArF) excimer laser light, and by adopting a process called multi-patterning, which combines the exposure process and the processing process a plurality of times, patterns with dimensions smaller than the wavelength of the exposure light have been formed.

However, since device patterns are continuously becoming finer and forming a finer pattern is becoming required, EUV lithography using extreme ultraviolet (hereinafter referred to as "EUV") light having a shorter wavelength than ArF excimer laser light is now being used as the exposure light. EUV light is light having the wavelength of about 0.2 to 100 nm, and more specifically, light having a wavelength of about 13.5 nm. Since this EUV light has extremely low transparency to substances and the conventional transmission type projection optical systems or masks cannot be used, a reflection-type optical device is used. In addition, a reflective mask has been proposed as a mask for pattern transfer.

A reflective mask is a mask in which a multilayer reflective film that reflects EUV light is formed on a substrate, and an absorber film that absorbs EUV light is formed in a pattern on the multilayer reflective film (hereinafter, this is referred to as the EUV reflective mask). On the other hand, the composite in the state before patterning on the absorber film (including the state in which the resist film has been formed) is called a reflective mask blank, and is used for the material for the reflective masks (hereinafter, this is referred to as the reflective mask blank for EUV).

If a concave- or convex-shaped defect is present on the surface layer or in the film of the reflective mask for EUV, the reflectance of EUV light decreases at the defective part, and the desired transfer pattern cannot be obtained when the wafer is exposed to the light. In particular, if a defect exists in the multilayer reflective film, or between the multilayer reflective film and the substrate, then even if the height of the defect is only a few nm, a phase shift in the reflected EUV light occurs in the surrounding area due to the collapse of the periodic structure of the multilayer reflective film, and this causes a local decrease in reflectance and significantly affects the pattern shape transferred to the wafer. Such a defect is called a phase defect. Phase defects are difficult to correct because they are located in the film or under the film. On the other hand, defects that exist on a multilayer reflective film or an absorber film are called amplitude defects in contrast to phase defects, because they attenuate the intensity of the reflected EUV light.

In order to avoid the effects of phase defects or amplitude defects on the transfer pattern, defect mitigation (hereinafter referred to as the DM technique) is being proposed in which phase defects are covered with an absorber pattern. In the DM technique, this is achieved by conducting a defect inspection to identify the defect position in a coordinate system defined by a reference mark produced on the reflective mask blank for EUV, measuring the reference mark position in the mask manufacturing process, and performing an appropriate coordinate conversion to obtain defect position information on the reflective mask blank for EUV in the coordinate system used in the mask manufacturing.

### CITATION LIST

### PATENT LITERATURE

Patent Document 1: JP 5910625 B2

### Non-patent Document

Non-Patent Document 1: SEMI P48-1110 (Reapproved 0416) - Specification of Fiducial Marks for EUV Mask Blank

### SUMMARY OF INVENTION

### TECHNICAL PROBLEM

Non-Patent Document 1 proposes a design for a reference mark that combines four large crosses that are each 550 µm long and 4 to 8 µm wide and seven small crosses that are each 100 µm long and 4 to 8 µm wide. Furthermore, Patent Document 1 states that FIB (focused ion beam, hereinafter referred to as FIB) methods and lithography methods using resist patterning and etching are suitably used as methods for forming a reference mark (paragraph [0073]). However, in order to conduct lithography, it is necessary to introduce numerous devices such as a coater, a drawing machine, a develop device, and an etching device, so the introduction cost is high, and for an FIB, the processing speed is slow. Therefore, reference marks such as those shown in Non-Patent Document 1 are difficult to produce at a relatively low cost and with high throughput. In addition, if the width of the reference mark is narrowed to shorten the processing time, problems arise such as deterioration of the positioning accuracy achieved by the detector.

The present invention has been provided to solve the above problems. The aim is to provide a reflective mask blank in which a reference mark can be produced at a relatively low cost and with high throughput, and the accuracy of the position detection by a detector can be improved and a method for manufacturing the same.

### SOLUTION TO PROBLEM

In order to solve the above problems, the present invention provides a reflective mask blank comprising at least:
a substrate;
a multilayer reflective film provided on the substrate and reflecting exposure light; and
an absorber film provided on the multilayer reflective film and absorbing the exposure light;
wherein the reflective mask blank comprises a reference mark serving as a reference position for detecting a defect position and formed on a surface of the reflective mask blank on a same side as the multilayer reflective film; and
the reference mark has at least two pairs of parallel line segments, each pair consisting of two parallel line segments in a concave or convex shape, and the directions of the two pairs of parallel line segments are in a position perpendicular to each other.

By using the reflective mask blank of the present invention, it is possible to produce a reference mark at a relatively low cost and with high throughput. In addition, by using the reflective mask blank of the present invention, the detection position accuracy of the reference mark achieved by the detector can be improved.

A width of each line segment of each pair of the parallel line segments is, for example, 1 µm or less.

The width of each line segment constituting each of the parallel line segment pairs is not particularly limited, but can be, for example, 1 µm or less. By thus limiting the width of each line segment constituting each of the parallel line segment pairs, the time taken to form the reference mark can be reduced.

In addition, the present invention provides a method for manufacturing a reflective mask blank comprising at least:
a step of forming a multilayer reflective film on a substrate, the multilayer reflective film reflecting exposure light; and
a step of forming an absorber film on the multilayer reflective film, the absorber film absorbing the exposure light;
wherein the method comprises a step of forming a reference mark on a surface of the reflective mask blank on a same side as the multilayer reflective film, the reference mark serving as a reference position for detecting a defect position, and
in the step of forming the reference mark,
the reference mark is formed so that the reference mark has at least two pairs of parallel line segments, each pair consisting of two parallel line segments in a concave or convex shape, and the directions of the two pairs of the parallel line segments are in a position perpendicular to each other.

According to the method for manufacturing the reflective mask blank of the present invention, it is possible to provide a reflective mask blank in which a reference mark is produced at a relatively low cost and with high throughput. Furthermore, according to the method for manufacturing a reflective mask blank of the present invention, a reflective mask blank having a reference mark capable of improving the detection position accuracy of the reference mark achieved by the detector can be provided.

For example, the reference mark may be formed so that each line segment of each pair of the parallel line segments has a width of 1 µm or less.

The width of each line segment constituting each of the parallel line segment pairs is not particularly limited, but can be, for example, 1 µm or less. By thus limiting the width of each line segment constituting each of the parallel line segment pairs, the time taken to form the reference mark can be reduced.

In addition, the reference mark can be formed by FIB processing in the step of forming the reference mark.

In this way, the reference mark and the reference mark forming region can be formed with high accuracy and at a relatively low cost.

### ADVANTAGEOUS EFFECTS OF INVENTION

According to the reflective mask blank of the present invention, the reference mark can be produced at a relatively low cost and with high throughput, and the detection position accuracy of the reference mark achieved by the detector can be improved.

Furthermore, according to the method for manufacturing the reflective mask blank of the present invention, a reflective mask blank on which a reference mark has been produced at a relatively low cost and with high throughput can be provided. Furthermore, according to the method for manufacturing a reflective mask blank of the present invention, a reflective mask blank having a reference mark capable of improving the detection position accuracy of the reference mark achieved by the detector can be provided.

### BRIEF DESCRIPTION OF DRAWINGS

FIG. 1 is a cross-sectional view of an example of a reflective mask blank of the present invention, in which the reference mark is concave.
FIG. 2 is a planar view showing a layout example of reference marks on the reflective mask blank of the present invention.
FIG. 3 is schematic view showing some examples of planar view shapes of the reference mark in the present invention.
FIG. 4 is a schematic cross-sectional view showing cross-sections A-A' in FIG. 3(a) in the cases where the reference mark is concave and where the reference mark convex in the present invention.

### DESCRIPTION OF EMBODIMENTS

As mentioned above, it was required to establish a technology that can process a reference mark at low cost and with high throughput in the production of a reference mark for reflective mask blanks. In addition, it is required to establish a technology that can improve the detection position accuracy of a reference mark achieved by the detector.

Therefore, the present inventors conducted a diligent study of reflective mask blanks, and found that according to a reflective mask blank (comprising at least a multilayer reflective film and an absorber film on a substrate) having a reference mark serving as a reference position for detecting a defect position, formed on a surface of the reflective mask blank on a same side as the multilayer reflective film, and having at least two pairs of parallel line segments, each pair consisting of two parallel line segments, with the directions of the two pairs of parallel line segments being in a position perpendicular to each other, the reference mark can be produced at a relatively low cost and with high throughput, and the detection position accuracy of the reference mark achieved by the detector can be improved. Consequently, they completed the present invention.

Furthermore, also with regard to the method for manufacturing the same, the present inventors found that a reflective mask blank with a reference mark can be manufactured by a method for manufacturing the same that has a step of forming a multilayer reflective film and an absorber film together with a step of forming a reference mark on a surface of the reflective mask blank on a same side as the multilayer reflective film, and in the step, the reference mark is formed so that it has at least two pairs of parallel line segments, each pair consisting of two parallel line segments, and the directions of the two pairs of parallel line segments are in a position perpendicular to each other, then the reference mark can be formed at a relatively low cost, and furthermore the detection position accuracy of the reference mark achieved by the detector can be improved. Consequently, they completed the present invention.

That is, the present invention provides a reflective mask blank comprising at least:
a substrate;
a multilayer reflective film provided on the substrate and reflecting exposure light; and
an absorber film provided on the multilayer reflective film and absorbing the exposure light;
wherein the reflective mask blank comprises a reference mark serving as a reference position for detecting a defect position and formed on a surface of the reflective mask blank on a same side as the multilayer reflective film; and
the reference mark has at least two pairs of parallel line segments, each pair consisting of two parallel line segments in a concave or convex shape, and the directions of the two pairs of parallel line segments are in a position perpendicular to each other.

In addition, the present invention provides a method for manufacturing a reflective mask blank comprising at least:
a step of forming a multilayer reflective film on a substrate, the multilayer reflective film reflecting exposure light; and
a step of forming an absorber film on the multilayer reflective film, the absorber film absorbing the exposure light;
wherein the method comprises a step of forming a reference mark on a surface of the reflective mask blank on a same side as the multilayer reflective film, the reference mark serving as a reference position for detecting a defect position, and
in the step of forming the reference mark,
the reference mark is formed so that the reference mark has at least two pairs of parallel line segments, each pair consisting of two parallel line segments in a concave or convex shape, and the directions of the two pairs of the parallel line segments are in a position perpendicular to each other.

Hereinafter, the present invention will be described in detail. However, the present invention is not limited thereto.

### [Reflective Mask Blank]

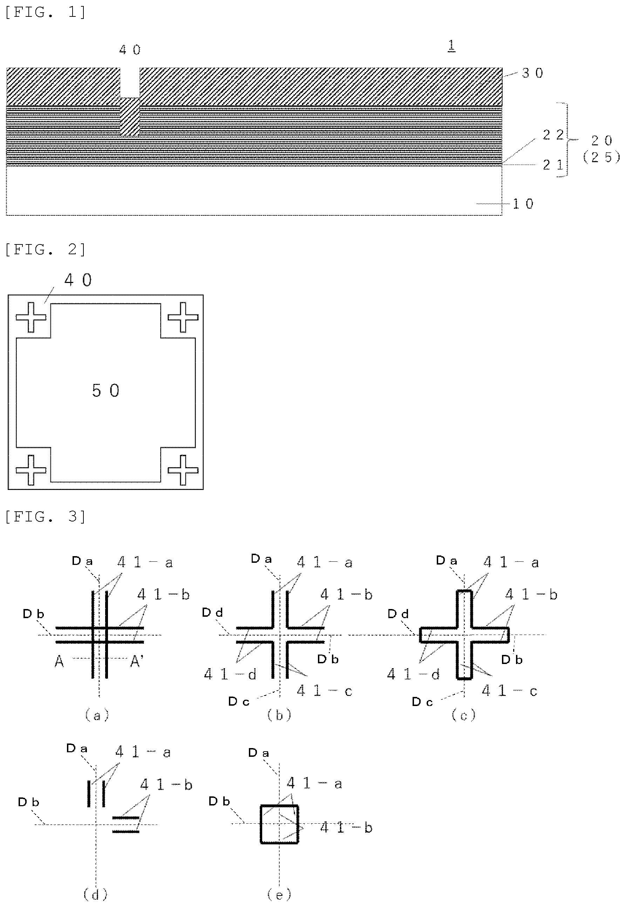

First, the reflective mask blank of the present invention will be described. FIG. 1 shows a cross-sectional view of an example of a reflective mask blank according to the present invention. Furthermore, below, a reflective mask blank for EUV will be described as an example, but the reflective mask blank of the present invention is not limited thereto.

In FIG. 1, the reflective mask blank 1 comprises a substrate 10, a multilayer reflective film 20 provided on the surface of the substrate 10 and reflecting exposure light, and an absorber film 30 provided on the multilayer reflective film 20 and absorbing the exposure light, and furthermore, has a reference mark 40 (serving as a reference position for a defect position) formed on the surface of the reflective mask blank.

Although not shown in FIG. 1, a protective film may be formed between the multilayer reflective film 20 and the absorber film 30 in order to prevent damage to the multilayer reflective film 20 when forming a pattern on the absorber film 30. Furthermore, a hard mask film may be provided on the absorber film 30, the hard mask film functioning as an etching mask when the absorber film 30 is dry-etched. In addition, a conductive film may be provided on the back side of the substrate 10, the conductive film functioning as an antistatic layer during electrostatic chucking. Furthermore, other functional layers may also be provided.

Hereinafter, each part will be described below using the embodiment shown in FIG. 1 as an example. However, the present invention is not limited thereto.

The substrate 10 preferably has low thermal expansion characteristics for use in EUV light exposure; for example, it is preferably formed from a material having a thermal expansion coefficient within the range of ±2×10⁻⁸/°C, and preferably within the range of ±5×10⁻⁹/°C. Furthermore, it is preferable to use a substrate having a sufficiently flat surface as the substrate 10. The surface roughness of a main surface of substrate 10 preferably has an RMS value of 0.5 nm or less, and particularly preferably 0.2 nm or less. Such a surface roughness can be achieved by polishing, etc. the substrate 10.

The multilayer reflective film 20 is generally a multilayer film in which a low-refractive-index material and a high-refractive-index material are alternately stacked. In this case, it is a film that reflects EUV light, which is the exposure light. In the embodiment shown in FIG. 1, the multilayer reflective film 20 has a layered part 25 comprising a plurality of layers, wherein a layer 21 having a relatively high refractive index to EUV light and a layer 22 having a relatively low refractive index to EUV light are alternately stacked. In this layered part 25, a structure in which Si (silicon) is used for the layer 21 having a relatively high refractive index to EUV light and Mo (molybdenum) is used for the layer 22 having a relatively low refractive index to EUV light and these are periodically stacked is suitably used (in this case, the layered part 25 is an Si/Mo layered part). Here, each of the Si layer 21 and the Mo layer 22 may be formed of each of single substance of silicon and single substance of molybdenum respectively, or they may contain other components. Furthermore, a diffusion-preventing layer may be provided between the Si layer 21 and the Mo layer 22. The diffusion-preventing layer may be provided as the all or some interlayers between all the Si layer 21 and the Mo layer 22.

The multilayer reflective film 20 can be formed by, for example, an ion beam sputtering method or a magnetron sputtering method.

The stack number of the Si layer 21 and the Mo layer 22 is preferably, for example, 40 cycles or more (40 layers or more of each), and is preferably 60 cycles or less (60 layers or less of each).

The thicknesses of the Si layer 21 and the Mo layer 22 of the Si/Mo layered part 25 are appropriately set according to the exposure wavelength, and the thickness of the Si layer 21 is preferably 5 nm or less, and the thickness of the Mo layer 22 is preferably 4 nm or less. The lower limit of the thickness of the Si layer 21 is not particularly limited, but is usually 1 nm or more. The lower limit of the thickness of the Mo layer 22 is not particularly limited, but is usually 1 nm or more. The thicknesses of the Si layer 21 and the Mo layer 22 may be set so as to obtain a high reflectance for EUV light. Furthermore, the thickness of each of the Si layer 21 and the Mo layer 22 may be constant or may vary from layer to layer. The total thickness of the Si/Mo layered part 25 is usually about 250 to 450 nm.

Furthermore, the multilayer reflective film 20 may be of a structure having an Si/Ru layered part 25 comprising a plurality of layers wherein the Si (silicon) layer 21 and an Ru (ruthenium) layer 22 are alternately stacked.

The material for the absorber film 30 is not particularly limited, as long as it is a material that can absorb exposure light and can undergo pattern processing. For the material for the absorber film 30, for example, a material containing tantalum (Ta) or chromium (Cr) is suitably used. Furthermore, the material containing Ta or Cr may contain oxygen (O), nitrogen (N), carbon (C), boron (B), etc. Examples of materials containing Ta include single substance of Ta and tantalum compounds such as TaO, TaN, TaON, TaC, TaCN, TaCO, TaCON, TaB, TaOB, TaNB, TaONB, TaCB, TaCNB, TaCOB, and TaCONB. Specific examples of materials containing Cr include single substance of Cr, and chromium compounds such as CrO, CrN, CrON, CrC, CrCN, CrCO, CrCON, CrB, CrOB, CrNB, CrONB, CrCB, CrCNB, CrCOB, and CrCONB. In addition, it may also be a multilayer structure formed from these materials. Furthermore, the absorber film 30 may function as a phase shift mask.

The absorber film 30 can be formed by, for example, an ion beam sputtering method or a magnetron sputtering method.

Furthermore, as described above, a protective film may be formed between the multilayer reflective film 20 and the absorber film 30. The protective film is required to have a function of protecting the multilayer reflective film 20 from various dry etching and washing in the reflective mask production process, the exposure environment when the reflective mask is used, washing treatment in the recycling process after use, etc. Ones having additive elements such as ruthenium (Ru), niobium (Nb), zirconium (Zr), and titanium (Ti) to give resistance to various processes are suitably used. Furthermore, a multilayer structure formed from those materials may be used.

The protective film can be formed by, for example, an ion beam sputtering method or a magnetron sputtering method.

A hard mask film (an etching mask film for the absorber film 30) having etching characteristics different from those of the absorber film 30 may be provided on the far side from the substrate 10 on the absorber film 30, and preferably in contact with the absorber film 30. This hard mask film functions as an etching mask when dry-etching the absorber film 30. After the absorber pattern is formed, this hard mask film may be left as a part of the absorber film 30 as a reflectance-reducing layer to reduce the reflectance at the wavelength of light used in an inspection such as a pattern inspection, or the hard mask may be removed so that it does not remain on the reflective mask for EUV.

For the material for the hard mask film, for example, a material containing chromium (Cr) is suitably used, and a multilayer structure may also be adopted. A hard mask film that is formed from a material containing Cr is particularly suitable if the absorber film 30 is formed from a material containing Ta but not containing Cr.

The hard mask film can be formed by, for example, a magnetron sputtering method.

The film thickness of the hard mask film is not particularly limited, but is usually about 5 to 20 nm.

A conductive film may be provided on the back side of the substrate 10 as an antistatic layer during electrostatic chucking. The conductive film preferably has a sheet resistance of 100 Ω/□ or less, and there are no particular restrictions on the material. For the material for the conductive film, for example, a material containing tantalum (Ta) or chromium (Cr) is suitably used. Furthermore, the material containing Ta or Cr may contain oxygen (O), nitrogen (N), carbon (C), boron (B), etc. Examples of materials containing Ta include single substance of Ta and tantalum compounds such as TaO, TaN, TaON, TaC, TaCN, TaCO, TaCON, TaB, TaOB, TaNB, TaONB, TaCB, TaCNB, TaCOB, and TaCONB. Examples of materials containing Cr include, specifically, single substance of Cr, and chromium compounds such as CrO, CrN, CrON, CrC, CrCN, CrCO, CrCON, CrB, CrOB, CrNB, CrONB, CrCB, CrCNB, CrCOB, and CrCONB. In addition, a multilayer structure formed from these materials may also be adopted.

The film thickness of the conductive film is not particularly limited, but is usually about 5 to 100 nm. The film thickness of the conductive film is preferably set so that, after the absorber pattern is formed, the film stress is balanced with the multilayer reflective film and the absorber pattern.

The conductive film may be formed before forming the multilayer reflective film 20, or after forming all the film on the multilayer reflective film 20 side of the substrate 10. Alternatively, a part of the films on the multilayer reflective film 20 side of the substrate 10 may be formed, and then the conductive film may be formed, and then the remaining films on the multilayer reflective film 20 side of the substrate 10 may be formed.

The conductive film can be formed by, for example, an ion beam sputtering method or a magnetron sputtering method.

Furthermore, the reflective mask blank for EUV may have a resist film that is formed on the side farthest from the substrate 10. The resist film is preferably a resist for electron beam (EB).

Next, the reference mark 40 will be described.

The reference mark 40 is formed on a same surface as the multilayer reflective film 30 of the reflective mask blank 10. The reference mark 40 is a mark that serves as a reference position for detecting a defect position.

FIG. 2 shows an example of the layout of the reference marks 40 on the reflective mask blank. Although in FIG. 2, the reference mark 40 is simplified for the purpose of explaining the layout, in reality, the reference mark 40 has at least two pairs of parallel line segments, as will be described later with reference to FIG. 3. In the example shown in FIG. 2, each of the reference marks 40 is arranged at each of the four corners on the surface of the same side as the multilayer reflective film 20 of the reflective mask blank 1. In the present invention, it is preferable that three or more of the reference marks 40 are formed so that the references marks are not on the same line. However, in the present invention, the location and number of the reference marks 40 are not particularly limited. It should be noted that, in order to prevent overlapping with the main pattern in the reflective mask for EUV, it is desirable to form the reference marks outside the main pattern forming region 50.

FIG. 3 shows five examples of the shape of the reference mark 40 in the present invention in planar view, but the shape of the reference mark in the present invention is not limited to these. In any of the examples, the reference mark 40 has at least two parallel line segment pairs 41-a and 41-b, each set consists of two parallel line segments having a concave or convex shape, and the directions of the two parallel line segment pairs 41-a and 41-b are in a position perpendicular to each other.

In FIG. 3(a), the reference mark 40 comprises two parallel line segment pairs 41-a and 41-b whose directions are perpendicular to each other, and each pair of parallel line segments comprises two parallel line segments. In addition, the directions Da and Db of the two parallel line segment pairs 41-a and 41-b are in a position perpendicular to each other.

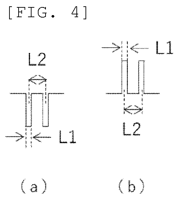

The concavity and convexity of the parallel line segments constituting the reference mark 40 are not particularly limited, and they may be either convex or concave. FIG. 4 shows cross-sectional views of the reference mark 40 shown in FIG. 3(a) taken along the line A-A' when the reference mark 40 is concave and when the reference mark 40 is convex, respectively. If it is concave, the methods for forming it include thermal processing or ablation using a laser, indentation using a microindenter, lithography, an FIB, etc. On the other hand, if it is convex, the methods for forming it include an inkjet method and the deposition function of an FIB. Since the reference mark 40 serves as a reference for detecting a defect position, it is desirable to form it using an FIB, with which highly accurate processing is possible. With an FIB, the target area is irradiated with the FIB to etch the irradiated region, and a concave shape can be made. On the other hand, by irradiating the target area with an FIB while spraying a compound gas onto the sample surface, deposition can be selectively performed on the irradiated region, and a convex shape can be made. The former is called the etching function of FIB, and the latter is called the deposition function of an FIB.

In FIG. 1, the reference mark 40 has been formed by removing a part of the multilayer reflective film 20. However, it may be formed by removing the entire multilayer reflective film 20 or by even removing the substrate underneath that. Alternatively, it may be formed on other layers, such as the substrate 10 or the absorber film 30. In addition, it may also be formed across a plurality of layers. Even if the reference mark 40 is convex, the layer on which the reference mark 40 is formed is not particularly limited. It should be noted that, in order to make the reference mark a reference position for a phase defect, it is desirable that the reference merk can be used as a reference position in a defect inspection of the multilayer reflective film 20, and that the mark is formed on the substrate 10, the multilayer reflective film 20, or the protective film.

The shape of the reference mark 40 in the present invention is not particularly limited. For example, as shown in FIG. 3(a), two parallel line segment pairs 41-a and 41-b whose directions Da and Db are perpendicular to each other can be arranged to intersect with each other to make it look like a cross shape. In this way, the area to be processed is not changed even if the width of the cross is increased, and the processing time can be reduced compared to cases where all the area inside the cross is processed.

The distance L2 between the two parallel line segments constituting each of the parallel line segment pairs 41-a and 41-b is preferably 300 nm or more and 10 µm or less.

In addition, as a variation example, as shown in FIG. 3(b) and FIG. 3(c), the shape of the reference mark 40 may be arranged so as to form the (or part of the) outline of a cross shape using four parallel line segment pairs, that is, two pairs 41-a and 41-b of parallel line segments whose directions Da and Db are perpendicular to each other, and another two pairs 41-c and 41-d of parallel line segments whose directions Dc and Dd are perpendicular to each other.

Alternatively, as shown in FIG. 3(d), two pairs 41-a and 41-b of parallel line segments whose directions Da and Db are perpendicular to each other may be arranged without intersecting each other. That is, in the present invention, the two pairs 41-a and 41-b of parallel line segments themselves do not have to be perpendicularly intersecting each other, as long as the directions Da and Db of the two pairs 41-a and 41-b of parallel line segments are in a position perpendicular to each other.

In addition, as another variation example, as shown in FIG. 3(e), the end points of two pairs 41-a and 41-b of parallel line segments whose directions Da and Db are perpendicular to each other may be overlapped and arranged to look like a rectangle.

In addition, if the reference mark 40 is concave, its depth is preferably 40 nm or more. If this is the case, when the inspection machine searches for the reference mark 40, sufficient contrast against the surroundings is ensured, and deterioration of detection position accuracy can be prevented. On the other hand, when forming the reference mark 40 using the etching function of an FIB, the depth is desirably 150 nm or less. Thus, the FIB processing time to a moderate length can be kept, and sufficient throughput can be achieved.

If the side wall angle of the reference mark 40 in the cross-sectional shape is made steeper, contrast during detection improves. Therefore, when forming the reference mark 40 using the etching function of an FIB, setting the electric current value to 100 pA or less is desirable.

Furthermore, if the reference mark 40 is convex, its height is desirably 40 nm or more. If this is the case, when the inspection machine searches for the reference mark 40, sufficient contrast against the surroundings is ensured and deterioration of detection position accuracy can be prevented. On the other hand, when forming the reference mark 40 using the deposition function of an FIB, the height is desirably 150 nm or less. Thus, pattern collapse due to an increase in the aspect ratio of the reference mark 40 can be prevented, the FIB processing time can also be kept to a moderate length, and sufficient throughput can be achieved.

The width L1 (the dimension parallel to the direction perpendicular to each of the directions Da to Db) of each of the line segments constituting the parallel line segment pairs 41-a to 41-b is not particularly limited, but may be, for example, 1 µm or less. By thus limiting the width of each line segment constituting the parallel line segment pairs, the time taken to form the reference mark can be reduced. It should be noted that if the side wall is tapered, the width of the line segment is defined using the full width at half maximum in the cross-sectional profile.

The length (the dimension parallel to each of the directions Da to Db)of each line segment constituting the parallel line segment pairs 41-a to 41-b is not particularly limited, but is preferably 5 µm or more and 1 mm or less.

Using FIG. 3(a) as an example, an example of a procedure for detecting the reference mark 40 with a detector will be described below.
Step 1. A light beam or an electron beam is scanned in a direction perpendicular to the two parallel line segments constituting the first parallel line pair 41-a.
Step 2. A line Da passing through the center of the two parallel line segments constituting the parallel line segment pair 41-a is obtained from the luminance profile of the reflected light in step 2.
Step 3. A light beam or an electron beam is scanned in the direction of the first parallel line segment pair 41-a and in a direction perpendicular to the two parallel lines constituting the second orthogonal line segment pair 41-b, which is perpendicular to the direction of the first parallel line segment pair 41-a.
Step 4. A line Db passing through the centers of the two parallel line segments constituting the parallel line segment pair 41-b is obtained from the luminance profile of the reflected light in step 3.
Step 5. The intersection of the two lines Da and Db in steps 2 and 4 is defined as the coordinates of the reference mark 40.

By adopting such a procedure, the detection position accuracy is improved compared to simply using the intersection of the line segments as the coordinates of the reference mark 40. The reasons for this are explained below.

Two lines X = X1 and X = X2 parallel to the Y-axis are considered. If the detection position accuracies of the X-coordinate of each line achieved by the detector follow mutually independent normal distributions with standard deviation, σ, the detection position accuracy of the average value, (X1+X2)/2, of the X-coordinates of the two lines is expressed by σ/√2, and the detection position accuracy is improved compared to the case of detecting a single line. According to this principle, by using the intersection of the center lines of the two parallel line segments constituting the parallel line segment pair 41-a and 41-b as the coordinates of the reference mark 40, the detection position accuracy can be expected to improve compared to the case of simply using the intersection of the line segments as the coordinates of the reference mark 40.

### [Method for Manufacturing Reflective Mask Blank]

Next, an inventive method for manufacturing the reflective mask blank of the present invention as shown in FIG. 1 will be described.

The manufacturing method according to the present invention has, as its main steps, at least a step of forming a multilayer reflective film 20 on a substrate 10, and a step of forming an absorber film 30 on the multilayer reflective film 20. Other functional layers such as the above-mentioned protective film, hard mask film, conductive film, and resist film can also be formed, as necessary. The methods for forming each of these films are not particularly limited, and for example, these films can be formed using the above-mentioned materials in the same manner as the conventional methods (such as an ion beam sputtering method and a magnetron sputtering method).

The manufacturing method according to the present invention further has a step of forming a reference mark 40 on the surface of a same side as the multilayer reflective film 20.

For further details, the reference mark 40 is formed so that the reference mark has at least two pairs of parallel line segments, each pair consisting of two parallel line segments in a concave or convex shape, and the directions of the two pairs of the parallel line segments are in a position perpendicular to each other.

For further details on the method for forming the reference mark 40, please refer to the above description.

It should be noted that, as described above, the reference mark 40 is preferably formed on the substrate 10, the multilayer reflective film 20, or the protective film. After the substrate 10 has been prepared or after those films have been formed, the reference mark can be formed with high accuracy by using, for example, the etching function or deposition function of an FIB.

### EXAMPLES

Hereinafter, the present invention will be described more specifically by referring Example and Comparative Examples. However, the present invention is not limited thereto.

### (Example 1)

On a substrate 10 comprising quartz glass of dimensions: 152 mm square; and 6.35 mm thick, a molybdenum (Mo) target and a silicon (Si) target were used, and both targets were placed facing the main surface of the substrate 10. While rotating the substrate 10, the multilayer reflective film 20 was formed by DC pulse magnetron sputtering.

For the preparation, each target was mounted on a sputtering device on which two targets can be mounted and discharged at one by one or both simultaneously, and then the substrate 10 was put in place. In the DC pulse magnetron sputtering, first, power was applied to the silicon (Si) target while flowing argon (Ar) gas into the chamber to form a silicon (Si) layer having a thickness of 4 nm, and then the application of power to the silicon (Si) target was stopped. Next, power was applied to the molybdenum (Mo) target while flowing argon (Ar) gas into the chamber to form a molybdenum (Mo) layer having a thickness of 3 nm, and then the application of power to the molybdenum (Mo) target was stopped. The operation to form the silicon (Si) layer and the molybdenum (Mo) layer was regarded as one cycle, and this cycle was repeated 40 times to obtain the multilayer reflective film 20.

Next, in order to form a protective film on the multilayer reflective film 20, an Ru target was used, and the Ru target was placed facing the main surface of the substrate 10. While rotating the substrate 10, a protective film in contact with the multilayer reflective film 20 was formed by DC pulse magnetron sputtering.

Next, by irradiating a designated part of the protective film with an FIB, the entire protective film and a part of the multilayer reflective film 20 in the irradiated part were removed. Thus two line segments having a width (horizontal width) L1 of 500 nm and a length (vertical width) of 100 µm in planar view were provided parallel to the Y-axis (direction Da), and a pair consisting of these two line segments were defined as the first parallel line segment pair 41-a. The distance L2 between the two line segments were set to 1.5 µm. Furthermore, a pair that was the same as the first parallel line segment pair 41-a was provided so that the pair perpendicularly intersected with the direction Da of the first parallel line segment pair 41-a at the center. This pair was defined as the second parallel line segment pair 41-b parallel to the X-axis (direction Db). As a result, a cross shape was produced to be located at the position where the directions Da and Db perpendicularly intersected with each other, as shown in FIG. 3(a), and this cross shape was defined as the reference mark 40. When doing this, the processing electric current was set to 500 pA, and it took about 4 minutes to process one mark. When the reference mark 40 was observed with an atomic force microscope (AFM), the depth of the reference mark 40 was 140 nm.

When the coordinate accuracy of each line segment constituting the reference mark 40 was confirmed using an ABICS E120 manufactured by Lasertec Corporation, the detection position accuracy (3σ) of the X-coordinate of each line segment constituting the first parallel line segment pair 41-a was 39.1 nm and 31.4 nm, respectively, and the detection position accuracy (3σ) of the X-coordinate of the line Da passing through the center of the parallel line segment pair 41-a was 28.2 nm. On the other hand, the detection position accuracy (3σ) of the Y-coordinate of each line segment constituting the second parallel line segment pair 41-b was 27.6 nm and 22.4 nm respectively, and the detection position accuracy (3σ) of the Y-coordinate of the line Db passing through the center of the parallel line segment pair 41-b was 20.6 nm. As described above, it was confirmed that by using the intersection of the center lines of the two parallel line segments constituting each of the parallel line segment pairs 41-a and 41-b as the coordinates of the reference mark 40, the detection position accuracy is improved compared to the case of simply using the intersection of the line segments as the coordinates of the reference mark 40.

Next, in order to form an absorber film 30 on the protective film, a Ta target was used, and the Ta target was placed facing the main surface of the substrate 10. While rotating the substrate 10, the absorber film 30 in contact with the protective film was formed by DC pulse magnetron sputtering. As a result, the reflective mask blank 1 for EUV of Example 1 was produced.

### (Comparative Example 1)

As Comparative Example 1, a reflective mask blank 1 of Comparative Example 1 was produced in the same manner as in Example 1, except that the shape of the reference mark 40 was formed to be a cross shape (the whole area inside the cross being processed) having a width of 500 nm and a length of 100 µm. When doing this, it took about 2 minutes to process one mark.

In the manufacturing process of the reflective mask blank 1 of Comparative Example 1, similarly to Example 1, before forming the absorber film, the central position accuracy (3σ) of the reference mark formed on the protective film was confirmed using an ABICS E120 manufactured by Lasertec Corporation, and that of the X-coordinate was 36.2 nm and that of the Y-coordinate was 25.2 nm.

### (Comparative Example 2)

As Comparative Example 2, a reflective mask blank 1 of Comparative Example 2 was produced in the same manner as in Example 1, except that the shape of the reference mark 40 was formed to be a cross shape (the whole area inside the cross being processed) having a width of 1.5 µm and a length of 100 µm. When doing so, it took about 6.5 minutes to process one mark.

To summarize the above results, in Example 1, the detection position accuracy (3σ) of the X-coordinate of the line Da passing through the center of the parallel line segment pair 41-a was 28.2 nm, and the detection position accuracy (3σ) of the Y-coordinate of the line Db passing through the center of the parallel line segment pair 41-b was 20.6 nm. These were smaller than the detected position accuracy (3σ) of the X-coordinate, 36.2 nm, and the detected position accuracy (3σ) of the Y-coordinate, 25.2 nm, in Comparative Example 1. Consequently, it was found that the detection position accuracies (3σ) of the X-coordinate and the Y-coordinate of Example 1 were superior compared to those of Comparative Example 1.

On the other hand, the processing time for Example 1 is 4 minutes, whereas the processing time for Comparative Example 2 is a longer time of 6.5 minutes, so it can be seen that Example 1 is superior to Comparative Example 2 from the viewpoint of productivity.

That is, as is clear from the above Examples and Comparative Examples, according to the reflective mask blank 1 of the present invention and the method for manufacturing the same of the present invention, the reference mark 40 can be produced at a relatively low cost and with high throughput, and even if the width of the reference mark is made narrower, the reference mark 40 can be detected without significantly deteriorating the positional accuracy achieved by the detector.

It should be noted that the present invention is not limited to the above embodiments. The embodiments described above are just examples, and any examples that have substantially the same components and demonstrate the same functions and effects as those in the technical concepts disclosed in the claims of the present invention are included in the technical scope of the present invention.

## Claims

1. A reflective mask blank comprising at least:
a substrate;
a multilayer reflective film provided on the substrate and reflecting exposure light; and
an absorber film provided on the multilayer reflective film and absorbing the exposure light;
wherein the reflective mask blank comprises a reference mark serving as a reference position for detecting a defect position and formed on a surface of the reflective mask blank on a same side as the multilayer reflective film; and
the reference mark has at least two pairs of parallel line segments, each pair consisting of two parallel line segments in a concave or convex shape, and the directions of the two pairs of parallel line segments are in a position perpendicular to each other.

2. The reflective mask blank according to claim 1, wherein a width of each line segment of each pair of the parallel line segments is 1 µm or less.

3. A method for manufacturing a reflective mask blank comprising at least:
a step of forming a multilayer reflective film on a substrate, the multilayer reflective film reflecting exposure light; and
a step of forming an absorber film on the multilayer reflective film, the absorber film absorbing the exposure light;
wherein the method comprises a step of forming a reference mark on a surface of the reflective mask blank on a same side as the multilayer reflective film, the reference mark serving as a reference position for detecting a defect position, and
in the step of forming the reference mark,
the reference mark is formed so that the reference mark has at least two pairs of parallel line segments, each pair consisting of two parallel line segments in a concave or convex shape, and the directions of the two pairs of the parallel line segments are in a position perpendicular to each other.

4. The method for manufacturing the reflective mask blank according to claim 3, wherein the reference mark is formed so that each line segment of each pair of the parallel line segments has a width of 1 µm or less.

5. The method for manufacturing the reflective mask blank according to claim 3 or **4,** wherein the reference mark is formed by FIB processing in the step of forming the reference mark.
